# EUROPÄISCHE PATENTSCHRIFT

(11) **EP 2 301 100 B1**
(45) Veröffentlichungstag und Bekanntmachung des Hinweises auf die Patenterteilung: **07.03.2012**
(21) Anmeldenummer: 09780174.0
(22) Anmeldetag: 06.07.2009
(51) Int. Cl.: H01M 8/04

(54) **VERFAHREN ZUR TEMPERATURREGELUNG IN EINER BRENNSTOFFZELLENANLAGE UND BRENNSTOFFZELLENANLAGE**
METHOD FOR TEMPERATURE CONTROL IN A FUEL CELL SYSTEM AND FUEL CELL SYSTEM
PROCÉDÉ DE RÉGULATION DE TEMPÉRATURE DANS UN SYSTÈME DE PILES À COMBUSTIBLE ET SYSTÈME DE PILES À COMBUSTIBLE

(30) Priorität: 08.07.2008 DE 102008032156
(43) Veröffentlichungstag der Anmeldung: 30.03.2011
(73) Patentinhaber: Siemens Aktiengesellschaft, 80333 München (DE); Howaldtswerke-Deutsche Werft GmbH, 24143 Kiel (DE)
(72) Erfinder: HAEBERLE, Markus, 90513 Zirndorf (DE); MUNDE, Robert, 24103 Kiel (DE)
(86) Internationale Anmeldenummer: PCT/EP2009/058488
(87) Internationale Veröffentlichungsnummer: WO 2010/003912

(56) Entgegenhaltungen:
- WO-A-2005/043661
- JP-A- 2003 017 105
- JP-A- 2006 049 182
- JP-A- 2007 317 559
- US-A- 3 539 397
- US-A- 3 595 699
- US-A1- 2006 172 164
- US-B1- 6 186 254

## Beschreibung

Die Erfindung betrifft ein Verfahren zur Temperaturregelung in einer Brennstoffzellenanlage mit zumindest einem Brennstoffzellenmodul und einer Kühlvorrichtung zum Kühlen des Brennstoffzellenmoduls, bei dem Kühlmittel durch das Brennstoffzellenmodul geführt wird und ein Prozessmittel eine Temperatur des Kühlmittels am Ausgang des Brennstoffzellenmoduls regelt. Außerdem betrifft die Erfindung eine Brennstoffzellenanlage mit zumindest einem Brennstoffzellenmodul, einer Kühlvorrichtung zum Führen von Kühlmittel durch das Brennstoffzellenmodul und mit einem Prozessmittel, das dazu vorgesehen ist, eine Temperatur des Kühlmittels zu regeln.

In einer Brennstoffzelle reagieren Wasserstoff (H₂) und Sauerstoff (O₂) an einem Elektrolyten unter Abgabe von Wärme und elektrischer Energie zu Produktwasser. Zum Erzeugen einer für große Stromverbraucher geeigneten Leistung werden eine Vielzahl von Brennstoffzellen in Reihe geschaltet und zu einem Brennstoffzellenmodul zusammengefasst, zum Beispiel in Form eines Stapels aus einer Vielzahl von plattenförmigen Brennstoffzellen.

Die bei dem elektrochemischen Prozess erzeugte Wärme wird zum größten Teil an ein Kühlmittel abgegeben, beispielsweise Wasser, das in einem Kühlmittelstrom die Brennstoffzellen eines Brennstoffzellenmoduls durch- oder umströmt. Die Menge der vom Brennstoffzellenmodul erzeugten thermischen Energie bzw. wärme ist abhängig von der Menge der im Brennstoffzellenmodul erzeugten elektrischen Energie, die wiederum abhängt von der Größe der elektrischen Last, die an das Brennstoffzellenmodul angeschaltet ist. Je größer die elektrische Last ist, desto mehr Wärme wird erzeugt und desto größer muss eine Kühlleistung des Kühlmittelstroms sein, um die Brennstoffzellen im Brennstoffzellenmodul innerhalb eines vorgegebenen Temperaturbereichs zu halten.

Zur Kühlung eines Brennstoffzellenmoduls ist es bekannt, die Temperatur des Kühlmittels an einem Kühlmittelausgang des Brennstoffzellenmoduls zu messen und zu regeln, wobei eine Stellgröße der Regelung beispielsweise eine Stellung eines Mischventils an einem Kühler ist.

Die Verwendung eines Stromflusses durch das Brennstoffzellenmodul zur Korrektur der Temperaturregelung ist beispielsweise aus der US 3,595,699, der US 6,186,254 und der US 2006/172164 A1 bekannt.

Es ist eine Aufgabe der vorliegenden Erfindung, ein Verfahren zur Temperaturregelung in einer Brennstoffzellenanlage und eine Brennstoffzellenanlage anzugeben, bei denen eine Temperatur der Brennstoffzellen des Brennstoffzellenmoduls sehr gleichmäßig gehalten werden kann.

Die auf das Verfahren gerichtete Aufgabe wird durch ein Verfahren der eingangs genannten Art gelöst, bei dem erfindungsgemäß die Kühlmitteltemperatur innerhalb des Brennstoffzellenmoduls gemessen wird und eine aus dem Messwert abgeleitete Störgröße und eine Änderung des elektrischen Stroms durch das Brennstoffzellenmodul als weitere Störgröße auf die Regelung aufgeschaltet werden. Bei einer Leistungserhöhung des Brennstoffzellenmoduls kann einer Temperaturerhöhung in den Brennstoffzellen frühzeitig entgegen gewirkt werden und die Temperatur kann zuverlässig in einem erlaubten Temperaturbereich gehalten werden.

Die Erfindung geht hierbei von der Überlegung aus, dass bei einem Lastanstieg des Brennstoffzellenmoduls ein Temperaturanstieg in den Brennstoffzellen bei einer Regelung der Ausgangstemperatur erst relativ spät im Regelkreis erfasst wird und die Kühlleistung des Kühlmittelstroms im Brennstoffzellenmodul daher erst relativ spät erhöht wird. Hierdurch kommt es - je nach Laständerungen - zu positiven oder negativen Temperaturspitzen, die außerhalb eines für das Brennstoffzellenmodul gewünschten Temperaturbereichs liegen können.

Um die Reaktionsgeschwindigkeit des Regelkreises zu erhöhen, kann die Regelung mit einer Steuerung kombiniert werden, beispielsweise indem die Kühlleistung in Abhängigkeit von der Last am Brennstoffzellenmodul bzw. vom Strom durch das Brennstoffzellenmodul gesteuert wird. Es ergibt sich hierdurch eine Kombination aus Regelung nach der Temperatur und Steuerung nach dem Strom des Brennstoffzellenmoduls. Auf diese Weise kann einer Erhöhung der Kühlmitteltemperatur bei einer Leistungssteigerung des Brennstoffzellenmoduls schnell entgegengewirkt werden.

Eine noch schnellere Reaktion gegen ein unerwünschtes Aufheizen von Kühlmittel im Brennstoffzellenmodul kann durch die Korrektur der Regelung anhand der Änderung des elektrischen Stroms durch das Brennstoffzellenmodul - im Folgenden als Stromgradient bezeichnet - erreicht werden. Bei einem kleinen Stromgradienten, also einer langsamen Änderung des elektrischen Stroms, wird die Regelung demzufolge leicht korrigiert und bei einer schnelleren Änderung des elektrischen Stroms stärker korrigiert. Der Stromgradient kann hierbei - beispielsweise anhand eines Kennfelds oder einer mathematischen Funktion - als Störgröße auf die Regelung aufgeschaltet und diese hierdurch korrigiert werden. Es kann eine vorausschauende Anpassung der Kühlleistung erreicht werden, wodurch trotz einer gewissen Zeitdauer, die das Kühlmittel zum Durchströmen des Brennstoffzellenmoduls braucht, eine schnelle Reaktion der Kühlleistung an die Wärmeerzeugung ermöglicht wird.

Die Erfindung ist besonders vorteilhaft anwendbar bei einem Brennstoffzellenblock, bei dem flache, vorzugsweise rechteckige Brennstoffzellen zu einem Block aufeinander gestapelt sind. Ein solcher Block kann zusammen mit Medienkanälen, Abschlussplatten, Befeuchtungszellen und weiteren Elementen das Brennstoffzellenmodul bilden. Als Kühlmittel kann eine Flüssigkeit vorgesehen sein, die vorzugsweise überwiegend aus Wasser besteht.

Die geregelte Temperatur ist eine Kühlmitteltemperatur am Ausgang des Brennstoffzellenmoduls. Auf diese weise kann die Kühlleistung des Kühlmittelstroms im Brennstoffzellenmodul besonders einfach geregelt werden.

Vorteilhafterweise umfasst die Kühlvorrichtung einen Kühlmittelkreislauf mit einem Kühler und einem Mischventil, mit dem ein Verhältnis zwischen durch den Kühler und am Kühler vorbei geführtem Kühlmittel eingestellt wird, wobei die Stellung des Mischventils eine Stellgröße der Regelung bildet. Hierdurch kann die Einstellung der Eingangstemperatur des Kühlmittels an einem Eingang des Brennstoffzellenmoduls und dadurch die Kühlleistung einfach erfolgen. Wird mehr Kühlmittel über den Kühler geführt, so sinkt die Eingangstemperatur des Kühlmittels und die Kühlleistung steigt - bei gleich bleibender Wärmeerzeugung im Brennstoffzellenmodul - an.

Eine zuverlässige und einfache Korrektur der Regelung kann erreicht werden, wenn die Änderung des elektrischen Stroms durch das Brennstoffzellenmodul als Störgröße auf eine Stellgröße der Regelung aufgeschaltet wird, insbesondere linear. Die Stellgröße, beispielsweise eine Ventilstellung des Mischventils, kann schnell und steuerungstechnisch einfach entsprechend des Stromgradienten korrigierend eingestellt werden, wobei bei ansteigendem Stromgradienten die korrigierend Verstellung der Stellgröße insbesondere entsprechend linear ansteigt. Bei gleich bleibendem Stromgradienten also gleichmäßig ansteigendem Strom durch das Brennstoffzellenmodul, kann die korrigierende Verstellung der Stellgröße konstant bleiben und bei konstantem Strom, also verschwindendem Stromgradienten, wieder auf Null zurückgenommen werden. Analog kann bei negativem Stromgradienten verfahren werden.

Um ein Aufschwingen des Regelkreises zu vermeiden erfolgt die Korrektur der Regelung zweckmäßigerweise nur innerhalb eines Stellbereichs einer Stellgröße der Regelung, der kleiner ist als der gesamte für eine reguläre Regelung zur verfügung stehende Stellbereich der Stellgröße.

Die Kühlmitteltemperatur wird innerhalb des Brennstoffzellenmoduls gemessen und eine aus dem Messwert abgeleitete Störgröße wird auf die Regelung aufgeschaltet. Hierfür umfasst die Brennstoffzellenanlage vorteilhafterweise zumindest einen Sensor im Brennstoffzellenmodul zur Erfassung der Temperatur innerhalb des Brennstoffzellenmoduls. Verlässt die Temperatur beispielsweise einen vorgegebenen Temperaturbereich, so wird eine zusätzliche Regelabweichung generiert, die zusätzlich zur Störgröße aus dem Stromgradienten auf die Regelung aufgeschaltet wird. Diese Störgrößenaufschaltung kann solange bestehen bleiben, wie die gemessene Temperatur innerhalb des Brennstoffzellenmoduls außerhalb des Temperaturbereichs liegt.

Zweckmäßigerweise ist die Störgröße eine progressive Störgröße, sodass z.B. bei einem Überschreiten der Temperatur über den oberen Grenzwert des Temperaturbereichs zunächst eine sanfte Regelabweichung erfolgt, die bei weiterem Ansteigen der Temperatur progressiv ansteigt.

Vorteilhafterweise umfasst die Kühlvorrichtung einen Mengengeber zum Einstellen der Stärke des Kühlmittelstroms durch das Brennstoffzellenmodul. Der Mengengeber kann ein Ventil sein oder eine Kühlmittelpumpe, deren Pumpleistung einstellbar ist. Auf diese Weise kann die Temperatur durch ein Einstellen der Pumpleistung eingestellt werden. Zweckmäßigerweise wird die Stärke des Kühlmittelstroms in Abhängigkeit von der Stärke des elektrischen Modulstroms durch das Brennstoffzellenmodul gesteuert, wodurch beispielsweise eine vorteilhafte Vorsteuerung erreicht werden kann.

Umfasst die Brennstoffzellenanlage zumindest zwei von jeweils einem Kühlmittelstrom durchströmte Brennstoffzellenmodule, so wird die Stärke aller Kühlmittelströme vorteilhafterweise in Abhängigkeit vom maximalen Strom der einzelnen Brennstoffzellenmodule gesteuert. Der momentan stärkste Modulstrom wird somit zum steuern der Stärke aller Kühlmittelströme durch die Brennstoffzellenmodule herangezogen, auch durch solche, bei denen der Modulstrom, also der Strom durch das Brennstoffzellenmodul, geringer ist. Hierzu werden die Modulströme zweckmäßigerweise separat erfasst, so dass sie verglichen werden können. Da bei gleichem Batterienstrom, der die Summe aller Modulströme sein kann, der Kühlmittelstrom vorteilhafterweise umso größer ist, je mehr Brennstoffzellenmodule gekühlt werden, wird der maximale Strom zweckmäßigerweise gewichtet zur Steuerung verwendet. Die Wichtung kann sich aus der Anzahl der gekühlten Brennstoffzellenmodule ergeben.

Soll ein Kühlmittelstrom durch ein Brennstoffzellenmodul beendet werden, während ein weiterer Kühlmittelstrom durch anderes Brennstoffzellenmodul weiter läuft, so ist es vorteilhaft, wenn die Stärke des weiteren Kühlmittelstroms unabhängig vom Modulstrom reduziert wird, bevor der andere Kühlmittelstrom beendet wird. Hierdurch kann vermieden werden, dass ein Druckstoß durch das den Modulstrom liefernde Brennstoffzellenmodul läuft, der zu einem Schaden an diesem Brennstoffzellenmodul führen kann.

Eine weitere Erfindungsvariante sieht eine Regelung des Temperaturunterschieds des Kühlmittels vor und nach dem Brennstoffzellenmodul vor. Diese Regelung kann eine Regelung sein, die parallel zur Temperaturregelung geschieht und insbesondere korrigierend wirkt. Zweckmäßigerweise ist eine Pumpleistung einer Kühlmittelpumpe eine Stellgröße der Regelung. Durch diese Regelung kann der Temperaturunterschied beispielsweise auf einen vorgegebenen Temperaturbereich geregelt werden. Der Temperaturunterschied ist ein Maß für die Stärke des Kühlmittelstroms durch das Brennstoffzellenmodul bzw. des Gesamtkühlmittelstroms durch alle Brennstoffzellenmodule. Durch die Verwendung des Temperaturunterschieds als Regelgröße kann der Kühlmittelstrom in einem besonders vorteilhaften Bereich gehalten werden. Hierdurch kann das Brennstoffzellenmodul geschont und ein hoher Wirkungsgrad des Brennstoffzellenmoduls über einen langen Zeitraum erhalten bleiben.

Vorteilhafterweise wird der Temperaturunterschied anhand einer Kennlinie über den Modulstrom geregelt. So kann der Soll-Temperaturunterschied bei niedrigen Strömen auf einen geringen Wert und bei hohen Strömen auf einen höheren Wert geregelt werden, z.B. auf 2°C bei 20% einer maximalen Modulleistung und auf 10° bei 100% der Modulleistung.

Bei mehreren Brennstoffzellenmodulen kann der Temperaturunterschied zwischen einem Eingang zu allen Brennstoffzellenmodulen und einem Ausgang aus allen Brennstoffzellenmodulen verwendet werden. Zweckmäßigerweise fließt in die Regelung ein, wie viele Brennstoffzellemodule durch die Kühlvorrichtung momentan gekühlt werden. Dies kann durch unterschiedliche Kennlinien - je nach Anzahl der Brennstoffzellenmodule, die in Betrieb sind - geschehen.

Zweckmäßigerweise sind die Kennlinien ab einer Leistung von 50% der maximalen Leistung der Brennstoffzellenanlage, insbesondere ab 70% von deren Leistung, konstant.

Die auf die Brennstoffzellenanlage gerichtete Aufgabe wird durch eine Brennstoffzellenanlage der eingangs genannten Art gelöst, bei der das Prozessmittel erfindungsgemäß dazu vorgesehen ist, die Kühlmitteltemperatur innerhalb des Brennstoffzellenmoduls zu erfassen und eine aus dem Messwert abgeleitete Störgröße und eine Änderung des elektrischen Stroms durch das Brennstoffzellenmodul als weitere Störgröße auf die Regelung aufzuschalten. Auf durch Laständerungen bedingte Temperaturschwankungen innerhalb des Brennstoffzellenmoduls kann schnell reagiert werden, sodass diese Schwankungen gering gehalten werden können. Das Prozessmittel ist vorteilhafterweise dazu vorgesehen, die oben beschriebenen Verfahrensschritte zu steuern bzw. zu regeln.

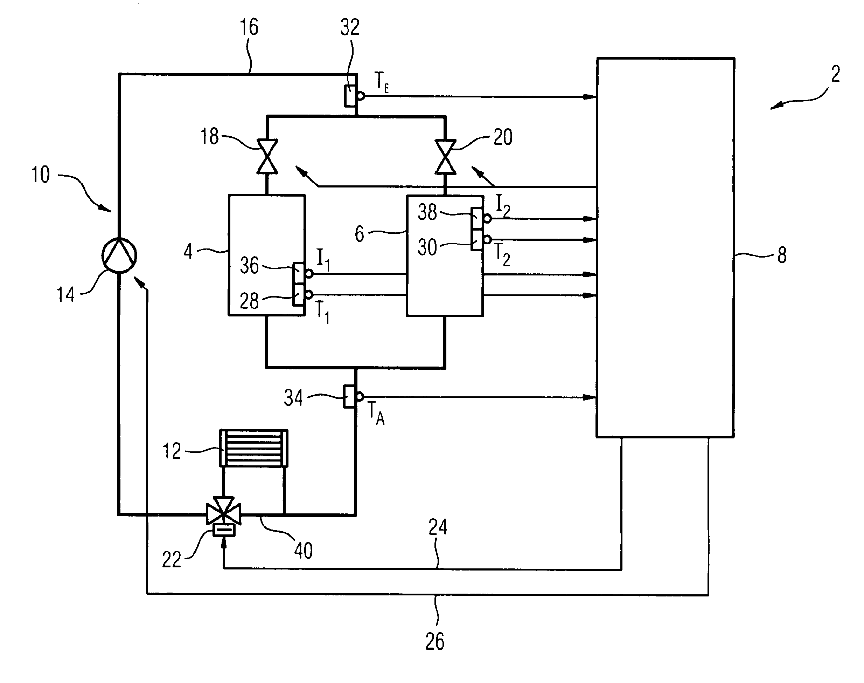

Die Erfindung wird anhand eines Ausführungsbeispiels näher erläutert, das in der Zeichnung dargestellt ist.

Die einzige Figur der Zeichnung zeigt eine Brennstoffzellenanlage 2 in einer stark vereinfachten und schematisierten Darstellung mit einem ersten Brennstoffzellenmodul 4 und einem zweiten Brennstoffzellenmodul 6, die zusammen eine Brennstoffzellenbatterie bilden. Beide Brennstoffzellenmodule 4, 6 sind elektrisch mit einer nicht dargestellten Last verbunden, beispielsweise einem Motor eines Fahrzeugs, den die beiden Brennstoffzellenmodule 4, 6 mit ihrem Strom mit Antriebsenergie versorgen, wobei diese Versorgung durch ein Prozessmittel 8 gesteuert ist.

Die Brennstoffzellenanlage 2 umfasst außerdem eine Kühlvorrichtung 10 mit einem Kühler 12 und einer Kühlmittelpumpe 14, die zum Pumpen von Kühlmittel durch einen Kühlmittelkreislauf 16 vorgesehen ist. Ein Kühlmittelstrom im Kühlmittelkreislauf 16 ist parallel auf die beiden Brennstoffzellenmodule 4, 6 aufgeteilt und durchströmt diese in zwei separaten Kühlmittelströmen, wobei die einzelnen Kühlmittelströme durch die Brennstoffzellenmodule 4, 6 durch jeweils ein Ventil 18, 20 separat an- oder abgeschaltet werden können. Der Kühlmittelkreislauf 16 umfasst außerdem ein Mischventil 22, durch das der Anteil des durch den Kühler 12 strömenden Kühlmittels vom gesamten Kühlmittelstrom im Kühlmittelkreislauf eingestellt werden kann.

Das Mischventil 22 wird vom Prozessmittel 8 gesteuert, das dem Mischventil 22 als Stellgröße in einem Regelkreis einen Sollwert 24 für die Stellung des Mischventils 22 vorgibt. Auch die Kühlmittelpumpe 14 wird vom Prozessmittel gesteuert, das der Kühlmittelpumpe 14 einen Sollwert 26 für dessen Drehzahl als Stellgröße in einem weiteren Regelkreis vorgibt. Des Weiteren werden die beiden Ventile 18, 20 vom Prozessmittel 8 angesteuert, dass deren Stellung "auf" oder "zu" vorgibt. Zwischenstellungen sind nicht vorgesehen.

Innerhalb der Brennstoffzellenmodule 4, 6 ist jeweils ein Temperatursensor 28, 30 vorhanden, die mit dem Prozessmittel 8 signaltechnisch verbunden sind, sodass die von Temperatursensoren 28, 30 gemessenen Temperaturen vom Prozessmittel 8 überwacht werden können. Außerdem sind zwei weitere Temperatursensoren 32, 34 außerhalb der Brennstoffzellenmodule 4, 6 im Kühlmittelkreislauf 16 angeordnet, wobei der Temperatursensor 32 die Eingangstemperatur T_{E} des Kühlmittels am Eingang der Brennstoffzellenbatterie misst und der Temperatursensor 34 die Ausgangstemperatur T_{A} am Ausgang der Brennstoffzellenbatterie. Mit entsprechenden Stromsensoren 36, 38 wird außerdem vom Prozessmittel 8 der Strom durch die beiden Brennstoffzellenmodule 4, 6 jeweils einzeln überwacht.

Während des Betriebs sei zunächst nur das erste Brennstoffzellenmodul 4 in Betrieb, während das zweite Brennstoffzellenmodul 6 abgeschaltet ist und keinen Strom erzeugt. Das Ventil 18 ist geöffnet, das Ventil 20 ist geschlossen und die elektrische Last ist nur an das erste Brennstoffzellenmodul 4 angeschaltet. Die im Brennstoffzellenmodul 4 erzeugte thermische Energie bzw. Wärme wird zum größten Teil an das Kühlmittel, dass das Brennstoffzellenmodul 4 durchströmt, abgegeben und zu einem anderen, kleineren Teil vom Brennstoffzellenmodul 4 nach außen abgestrahlt. Das erwärmte Kühlmittel wird teilweise durch den Kühler 12 und teilweise durch einen Bypass 40 am Kühler 12 vorbeigeführt, entsprechend der Stellung des Mischventils 22. Die Stärke des Kühlmittelstroms im Kühlmittelkreislauf 16 und damit durch das Brennstoffzellenmodul 4 wird durch die Drehzahl der Kühlmittelpumpe 14 vorgegeben.

Die Ausgangstemperatur T_{A} des Kühlmittels am Temperatursensor 34 wird ständig vom Prozessmittel 8 überwacht und als Regelgröße für eine Temperaturregelung verwendet. Als Stellwert in dieser Regelung wird der Sollwert 24 der Stellung des Mischventils 22 verwendet, und der Vorgabewert für die Regelung ist eine Temperatur von 75°C als Ausgangstemperatur T_{A}. Steigt diese über 75°C an, so wird das Mischventil 22 zum Kühler 12 hin weiter geöffnet und damit wird der Anteil des den Kühler 12 durchströmenden Kühlmittels erhöht, wodurch die Eingangstemperatur T_{E} sinkt und damit auch - bei stabilen Betriebsverhältnissen - die Ausgangstemperatur T_{A} nach einer Weile. Durch die Temperaturregelung wird die Kühlleistung des Kühlmittelstroms im Brennstoffzellenmodul 4 indirekt geregelt.

Tritt während des Betriebs eine Änderung der elektrischen Last auf, so ändert sich die Größe des vom Brennstoffzellenmodul 4 erzeugten Stroms entsprechend. Hierdurch wird auch die Erzeugung der Wärme im Brennstoffzellenmodul 4 beeinflusst, wobei die erzeugte Wärme mit steigendem Strom ansteigt. Das Brennstoffzellenmodul 4 wird in seinem Inneren wärmer, es wird mehr Wärme an den Kühlmittelstrom abgegeben, die Kühlleistung steigt und mit ihr die Ausgangstemperatur T_{A}. Infolge der Regelung wird das Mischventil 22 in Richtung zum Kühler 12 weiter geöffnet, es strömt mehr Kühlmittel durch den Kühler 12, dort wird mehr Wärme vom Kühlmittel abgegeben, sodass die Eingangstemperatur T_{E} beispielsweise konstant auf 65°C gehalten werden kann oder bei einer weitergehenden Regelung die Eingangstemperatur T_{E} zum Kompensieren der größeren erzeugten Wärmemenge im Brennstoffzellenmodul 4 auf einen niedrigeren Wert absinkt.

Zusätzlich zu dieser Regelung wird die Kühlleistung des Kühlmittelstroms im Brennstoffzellenmodul 4 vom Prozessmittel 8 durch ein Einstellen des Sollwerts 26 der Drehzahl der Kühlmittelpumpe 14 gesteuert. Die Steuerung geschieht in Abhängigkeit vom Strom I₁ durch das Brennstoffzellenmodul 4, sodass entsprechend einer mathematischen Umrechnung oder einer Kennlinie die Drehzahl bei großem Strom I₁ groß ist und bei kleinerem Strom I₁ kleiner ist. Durch die höhere Drehzahl der Kühlmittelpumpe 14 strömt das Kühlmittel schneller durch das Brennstoffzellenmodul 4, der Kühlmittelstrom ist also größer, wodurch einer durch eine höhere Stromproduktion bedingte höhere Wärmeerzeugung im Brennstoffzellenmodul 4 mit einer höheren Kühlleistung Rechnung getragen wird.

Bei einer großen Leistungserhöhung des Brennstoffzellenmoduls 4 kann es aufgrund der schnell ansteigenden Menge an erzeugter Wärmeenergie trotz der Steuerung nach dem Strom zu einem erheblichen Temperaturanstieg innerhalb des Brennstoffzellenmoduls 4 kommen. Um diesem Temperaturanstieg entgegen zu wirken, wird die Änderung des elektrischen Stroms durch das Brennstoffzellenmodul 4, also der Stromgradient, als Korrekturgröße für die beschriebene Regelung verwendet. Hierzu wird der Strom I₁ durch das Brennstoffzellenmodul 4 kontinuierlich vom Prozessmittel 8 überwacht und ein Stromgradient wird erkannt. Bei positivem Stromgradienten wird dieser - vom Prozessmittel 8 umgewandelt in eine Stellwertänderung - linear auf den Sollwert 24 der Stellung des Mischventils 22 aufgeschaltet. Verdoppelt sich beispielsweise der positive Stromgradient, so verdoppelt sich auch die positive Stellwertänderung, das Mischventil 22 wird also doppelt so weit zusätzlich zum Kühler 12 hin geöffnet. Ist der Stromgradient konstant, beispielsweise weil der Strom I₁ kontinuierlich linear ansteigt, ist auch die Störgröße, die auf die Regelung aufgeschaltet wird, konstant. Verschwindet der Stromgradient so wird auch das Aufschalten der Störgröße auf die Regelung beendet.

Das Mischventil 22 öffnet somit im Wesentlichen zeitgleich mit dem Auftreten eines z.B. positiven Stromgradienten in Richtung zum Kühler 12 hin, sodass die Eingangstemperatur T_{E} innerhalb von kurzer Zeit sinkt. Hierdurch wird einer Erwärmung des Brennstoffzellenmoduls 4 sehr zügig entgegengewirkt, ohne auf eine Reaktion der Ausgangstemperatur T_{A} als Regelgröße auf den positiven Stromgradienten warten zu müssen. Bei negativem Stromgradienten, also bei einer Verringerung der Last am Brennstoffzellenmodul 4, kann unter Berücksichtigung des anderen Vorzeichens analog verfahren werden.

Steigt die Temperatur T₁ im Brennstoffzellenmodul 4 aus irgendeinem Grund, beispielsweise durch einen sehr hohen positiven Stromgradienten, über einen vorbestimmten Wert, z. B. 85°C, so wird dies vom Prozessmittel 8 erkannt, dass die Temperatur T₁ kontinuierlich überwacht. Es wird dann vom Prozessmittel 8 eine Regelabweichung generiert, die als Störgröße auf die Stellgröße, also den Sollwert 24 der Stellung des Mischventils 22, aufgeschaltet wird. Diese Aufschaltung ist zusätzlich zu der durch den Stromgradienten bedingten Aufschaltung. Das Mischventil 22 wird also noch weiter geöffnet als durch die Temperaturregelung und einer evt1. Aufschaltung durch den Stromgradient vorgegeben ist. Analog und mit umgekehrtem Vorzeichen der Störgröße kann bei einer Temperatur T₁ im Brennstoffzellenmodul 4 unter einen vorbestimmten Wert verfahren werden.

Zusätzlich zu der Steuerung der Drehzahl der Kühlmittelpumpe 14 kann die Drehzahl geregelt werden. Als Regelgröße kann die Temperaturdifferenz zwischen der Ausgangstemperatur T_{A} und der Eingangstemperatur T_{E} verwendet werden. Hierbei ist es allerdings vorteilhaft, wenn ein Temperaturbereich der Regelgröße vorgesehen ist, innerhalb dessen die Regelungen ausgesetzt wird. Der Bereich kann beispielsweise von 9°C bis 12°C gehen, oder sogar noch enger von 10°C bis 11°C gehen. Erst wenn die Temperaturdifferenz über einen vorbestimmten Wert steigt, beispielsweise über 11°C, so kann die Regelung einsetzen mit einer entsprechenden Regelung der Drehzahl der Kühlmittelpumpe 14. Selbstverständlich ist es auch möglich, einen scharfen Wert für die anstrebte Temperaturdifferenz, beispielsweise 10,5°C, vorzugeben und die Steuerung durch eine kontinuierliche Korrekturregelung zu überlagern. Je nach Anzahl der in Betrieb befindlichen Brennstoffzellenmodule 2, 4 können unterschiedliche Grenzwerte vorgegeben sein.

Diese Regelung überlagert die Steuerung der Drehzahl anhand des Strom I₁ und ist als Korrekturregelung vorgesehen, die die Temperaturdifferenz regelt, z.B. in einem vorgegebenen Bereich. Überschreitet die Temperaturdifferenz den Sollwert oder den oberen Grenzwert des regelungsfreien Bereichs, so wird die Drehzahl der Kühlmittelpumpe 14 erhöht. Analog hierzu wird die Drehzahl bei einem Unterschreiten der Temperaturdifferenz unter den Sollwert bzw. unter die untere Grenze des regelungsfreien Bereichs verringert.

Bei einem Betrieb mit beiden Brennstoffzellenmodulen 4, 6 kann die beschriebene Steuerung und die Regelungen gleicherweise für beide Brennstoffzellenmodule 4, 6 erfolgen.

Bei einem, Zuschalten des zweiten Brennstoffzellenmoduls 6 zum ersten Brennstoffzellenmodul 4, so wird das zweite Ventil 20 geöffnet und somit ein zusätzlicher Kühlmittelstrom erzeugt, der durch das zweite Brennstoffzellenmodul 6 hindurchgeführt ist. Bei gleich bleibender Drehzahl der Kühlmittelpumpe 14 verteilt sich nun der gesamte Kühlmittelstrom aus dem Kühlmittelkreislauf 16 auf beide Brennstoffzellenmodule 4, 6, sodass das noch den vollen Strom tragende Brennstoffzellenmodul 4 weniger gekühlt wird. Um einer hierdurch bedingten Temperaturerhöhung im Brennstoffzellenmodul 4 entgegenzuwirken, kann die Steuerung der Drehzahl zusätzlich in Abhängigkeit zu der Anzahl der gekühlten Brennstoffzellenmodule 4, 6 erfolgen.

Nach etwa drei Minuten Startzeit übernimmt das zweite Brennstoffzellenmodul 6 einen Teil der elektrischen Last, sodass der Strom durch das erste Brennstoffzellenmodul 4 abnimmt. Die elektrische Last verteilt sich nun beispielsweise gleichmäßig auf die beiden Brennstoffzellenmodule 4, 6. Es besteht nun die Möglichkeit, die Steuerung der Drehzahl der Kühlmittelpumpe 14 in Abhängigkeit des Batteriestroms durchzuführen, also des Gesamtstroms durch alle Brennstoffzellenmodule 4, 6.

Bei einer solchen Steuerung wird allerdings nicht berücksichtigt, dass die elektrische Leistung bzw. der Strom durch die Brennstoffzellenmodule 4, 6 auch ungleich verteilt sein kann, sodass eines der Brennstoffzellenmodule 4, 6 einer größeren Kühlleistung bedarf als das andere. Da beide Ventile 18, 20 offen sind, verteilt sich der gesamte Kühlmittelstrom des Kühlmittelkreislaufs 16 gleichmäßig auf die beiden Kühlmittelströme durch die Brennstoffzellenmodule 4, 6. Wird also beispielsweise die Verteilung der elektrischen Last durch das Prozessmittel 8 von einer gleichmäßigen Aufteilung auf die Brennstoffzellenmodule 4, 6 geändert in eine ungleichmäßige Aufteilung, so ändert sich die Stärke des Kühlmittelstroms durch dieses Brennstoffzellenmodul 4, 6 nicht obgleich dort mehr Wärme erzeugt wird. Da in dem anderen Brennstoffzellenmodul 4, 6 weniger Wärme erzeugt wird, wird die Änderung der Stromverteilung auch nicht oder nur ungenügend durch eine Änderung der Ausgangstemperatur T_{A} oder eine Temperaturdifferenz zwischen der Ausgangstemperatur T_{A} und der Eingangstemperatur T_{E} erfasst.

Um diesen Nachteil zu vermeiden, wird die Drehzahl der Kühlmittelpumpe 14 in Abhängigkeit maximalen Strom I₁, I₂ durch die Brennstoffzellenmodule 4, 6 gesteuert. Trägt beispielsweise das erste Brennstoffzellenmodul 4 die größere elektrische Last, so ist die Drehzahl abhängig von dessen Strom I₁ und unabhängig vom Strom I₂ durch das zweite Brennstoffzellenmodul 6. Das andere und weniger Strom tragende Brennstoffzellenmodul 6 wird hierdurch zwar stärker gekühlt als notwendig, dies ist jedoch tolerierbar.

Allerdings kann eine derartige Steuerung der Drehzahl der Kühlmittelpumpe 14 bewirken, dass die Temperaturdifferenz durch den Zustrom von relativ kaltem Kühlmittel aus dem wenig Strom tragenden Brennstoffzellenmodul 4 zum Temperatursensor 34 stark absinkt. Eine Korrekturregelung der Drehzahl der Kühlmittelpumpe 14 wäre die Folge, sodass die Kühlleistung in beiden Brennstoffzellenmodulen 4, 6 absinkt und das den größten Strom tragende Brennstoffzellenmodul 4 weniger gekühlt werden würde. Um diesen Effekt zu vermeiden oder gering zu halten, fließt in die temperaturabhängige Korrekturregelung ein, wie viele Brennstoffzellenmodule 4, 6 durch die Kühlvorrichtung 10 momentan gekühlt werden. Bei mehreren Brennstoffzellenmodulen 4, 6 kann der regelungsfreie Bereich beispielsweise nach unten erweitert werden, sodass die Korrekturregelung auch bei einer geringen Temperaturdifferenz noch nicht einschreitet.

Wird nun ein Brennstoffzellenmodul 4, 6 abgeschaltet, beispielsweise das erste Brennstoffzellenmodul 4, wohingegen das andere Brennstoffzellenmodul 6 weiter in Betrieb bleibt, wird nach dem Abschalten des elektrischen Stroms vom Brennstoffzellenmodul 4 dieses noch einen Zeitraum weiter gekühlt, um Restwärme aus dem Brennstoffzellenmodul 4 heraus zu tragen. Dann wird das entsprechende Ventil 18 geschlossen und der Kühlmittelstrom durch das Brennstoffzellenmodul 4 kommt zum Erliegen. Der volle Kühlmittelstrom wird durch das Strom tragende Brennstoffzellenmodul 6 hindurch getrieben. Einer Kühlung ist dieser Vorgang zwar nicht schädlich, jedoch ggf. einer Langlebigkeit und einem Wirkungsgrad des Brennstoffzellenmoduls 6. Ein solcher Druckstoß sollte somit vermieden werden. Da die Pumpleistung einer Gleichstrompumpe in der Regel nur langsam heruntergefahren werden kann, wird die Drehzahl der Kühlmittelpumpe 14 bereits einen Zeitraum vor dem Schließen des Ventils 18, also vor einem Stoppen des Kühlmittelstroms durch das Brennstoffzellenmodul 4, vom Prozessmittel 8 im Hinblick auf das Abschalten des Brennstoffzellenmoduls 4 reduziert. Dieses Reduzieren erfolgt zweckmäßigerweise erst nach dem Zeitabschnitt, der zum Nachkühlen vorgesehen ist und der nach dem Abschalten des Brennstoffzellenmoduls 4 von der elektrischen Last beginnt. Erst nach abgeschlossener Drehzahlreduzierung der Kühlmittelpumpe 14 wird das Ventil 18 geschlossen und der Kühlmittelstrom vollständig durch das zweite Brennstoffzellenmodul 6 geführt.

Bei dem dargestellten Ausführungsbeispiel wurden die Verfahrensschritte nur für zwei Brennstoffzellenmodule 4, 6 erläutert. Selbstverständlich sind sie in gleicher Weise auch auf eine Brennstoffzellenanlage mit mehr Brennstoffzellenmodulen anwendbar, die einzeln, in einer Gruppe oder alle zusammen betrieben werden können.

## Patentansprüche

1. Verfahren zur Temperaturregelung in einer Brennstoffzellenanlage (2) mit zumindest einem Brennstoffzellenmodul (4, 6) und einer Kühlvorrichtung (10) zum Kühlen des Brennstoffzellenmoduls (4, 6), bei dem Kühlmittel durch das Brennstoffzellenmodul (4, 6) geführt wird und ein Prozessmittel (8) eine Temperatur des Kühlmittels am Ausgang des Brennstoffzellenmoduls (4, 6) regelt,
**dadurch gekennzeichnet, dass** die Kühlmitteltemperatur innerhalb des Brennstoffzellenmoduls (4, 6) gemessen wird und eine aus dem Messwert abgeleitete Störgröße und eine Änderung des elektrischen Stroms (I₁, I₂) durch das Brennstoffzellenmodul (4, 6) als weitere Störgröße auf die Regelung aufgeschaltet werden.

2. Verfahren nach Anspruch 1,
**dadurch gekennzeichnet, dass** die Kühlvorrichtung (10) einen Kühlmittelkreislauf (16) mit einem Kühler (12) und einem Mischventil (22) aufweist, mit dem ein Verhältnis zwischen durch den Kühler (12) und am Kühler (12) vorbei geführtem Kühlmittel eingestellt wird, wobei die Stellung des Mischventils (22) eine Stellgröße der Regelung bildet.

3. Verfahren nach einem der vorhergehenden Ansprüche,
**dadurch gekennzeichnet, dass** die Änderung des elektrischen Stroms durch das Brennstoffzellenmodul (4, 6) als Störgröße auf eine Stellgröße der Regelung aufgeschaltet wird. ,

4. Verfahren nach einem der vorhergehenden Ansprüche,
**dadurch gekennzeichnet, dass** die Temperatur durch ein Einstellen einer Pumpleistung einer Kühlmittelpumpe (14) eingestellt wird.

5. Verfahren nach einem der vorhergehenden Ansprüche,
**dadurch gekennzeichnet, dass** die Stärke des Kühlmittelstroms in Abhängigkeit von der Stärke des elektrischen Stroms (I₁, I₂) durch das Brennstoffzellenmodul (4, 6) gesteuert wird.

6. Verfahren nach einem der vorhergehenden Ansprüche,
**dadurch gekennzeichnet, dass** die Brennstoffzellenanlage (2) zumindest zwei von jeweils einem Kühlmittelstrom durchströmte Brennstoffzellenmodule (4, 6) aufweist und die Stärke aller Kühlmittelströme in Abhängigkeit vom maximalen Strom (I₁, I₂) der einzelnen Brennstoffzellenmodule (4, 6) gesteuert wird.

7. Verfahren nach Anspruch 6,
**dadurch gekennzeichnet, dass** die Stärke eines Kühlmittelstroms durch ein einen Modulstrom lieferndes Brennstoffzellenmodul (4, 6) unabhängig vom Modulstrom reduziert wird, bevor ein Kühlmittelstrom durch ein anderes Brennstoffzellenmodul (4, 6) gestoppt wird.

8. Verfahren nach einem der vorhergehenden Ansprüche,
**gekennzeichnet durch** eine Regelung des Temperaturunterschieds des Kühlmittels vor und nach dem Brennstoffzellenmodul (4, 6).

9. Verfahren nach Anspruch 8,
**dadurch gekennzeichnet, dass** in die Korrekturregelung einfließt, wie viele Brennstoffzellenmodule (4, 6) durch die Kühlvorrichtung (10) momentan gekühlt werden.

10. Brennstoffzellenanlage (2) mit zumindest einem Brennstoffzellenmodul (4, 6), einer Kühlvorrichtung (10) zum Führen von Kühlmittel durch das Brennstoffzellenmodul (4, 6) und mit einem Prozessmittel (10), das dazu vorgesehen ist, eine Temperatur des Kühlmittels am Ausgang des Brennstoffzellenmoduls (4, 6) zu regeln, ,
**dadurch gekennzeichnet, dass** das Prozessmittel (8) dazu vorgesehen ist, die Kühlmitteltemperatur innerhalb des Brennstoffzellenmoduls (4, 6) zu erfassen und eine aus dem Messwert abgeleitete störgröße und eine Änderung des elektrischen Stroms (I₁, I₂) durch das Brennstoffzellenmodul (4, 6) als weitere Störgröße auf die Regelung aufzuschalten.

## Claims

1. Method for temperature regulation in a fuel cell installation (2) having at least one fuel cell module (4, 6) and a cooling apparatus (10) for cooling the fuel cell module (4, 6), in which coolant is passed through the fuel cell module (4, 6), and a process means (8) regulates a temperature of the coolant at the outlet of the fuel cell module (4,6),
**characterized in that** the coolant temperature within the fuel cell module (4, 6) is measured, and a disturbance variable derived from the measured value and a change in the electric current (I₁, I₂) through the fuel cell module (4, 6) as a further disturbance variable are applied to the regulation.

2. Method according to Claim 1,
**characterized in that** the cooling apparatus (10) has a coolant circuit (16) with a cooler (12) and a mixing valve (22), by means of which a ratio is set between coolant which is passed through the cooler (12) and coolant which bypasses the cooler (12), wherein the position of the mixing valve (22) forms a manipulated variable of the regulation.

3. Method according to one of the preceding claims,
**characterized in that** the change in the electric current through the fuel cell module (4, 6) is applied as a disturbance variable to a manipulated variable of the regulation.

4. Method according to one of the preceding claims,
**characterized in that** the temperature is set by adjusting a pump power of a coolant pump (14).

5. Method according to one of the preceding claims,
**characterized in that** the strength of the coolant flow is controlled as a function of the level of the electric current (I₁, I₂) through the fuel cell module (4, 6).

6. Method according to one of the preceding claims,
**characterized in that** the fuel cell installation (2) has at least two fuel cell modules (4, 6), through each of which coolant flows, and the strength of all the coolant flows is controlled as a function of the maximum current (I₁, I₂) in the individual fuel cell modules (4, 6).

7. Method according to Claim 6,
**characterized in that** the strength of a coolant flow through a fuel cell module (4, 6) which produces a module current is reduced, independently of the module current, before a coolant flow through another fuel cell module (4, 6) is stopped.

8. Method according to one of the preceding claims,
**characterized by** regulation of the temperature difference of the coolant before and after the fuel cell module (4, 6).

9. Method according to Claim 8,
**characterized in that** how many fuel cell modules (4, 6) are instantaneously being cooled by the cooling apparatus (10) is included in the correction regulation.

10. Fuel cell installation (2) having at least one fuel cell module (4, 6), a cooling apparatus (10) for passing coolant through the fuel cell module (4, 6), and having a process means (10), which is intended to regulate a temperature of the coolant at the outlet of the fuel cell module (4, 6),
**characterized in that** the process means (8) is intended to detect the cooling temperature within the fuel cell module (4, 6) and to apply a disturbance variable derived from the measured value and a change in the electric current (I₁, I₂) through the fuel cell module (4, 6) as a further disturbance variable, to the regulation.

## Revendications

1. Procédé de régulation de la température dans une installation (2) de piles à combustible, ayant au moins un module (4, 6) de piles à combustible et un dispositif (10) de refroidissement, pour le refroidissement du module (4, 6) de piles à combustible, dans lequel on envoie du fluide de refroidissement dans le module (4, 6) de piles à combustible et un moyen (8) de processus règle une température du fluide de refroidissement à la sortie du module (4, 6) de piles à combustible,
**caractérisé en ce que** l'on mesure la température du fluide de refroidissement à l'intérieur du module ( 4, 6 ) de piles à combustible et on applique à la régulation une grandeur de perturbation déduite de la valeur de mesure et une variation du courant (I₁, I₂) dans le module (4, 6) de piles à combustible comme autre grandeur de perturbation.

2. Procédé suivant la revendication 1,
**caractérisé en ce que** le dispositif (10) de refroidissement comporte un circuit (16) pour du fluide de refroidissement ayant un refroidisseur (12) et un robinet (22) de mélange, par lequel on établit un rapport entre du fluide de refroidissement passant dans le refroidisseur (12) et du fluide de refroidissement contournant le refroidisseur (12), la position du robinet (22) de mélange formant une grandeur de réglage de la régulation.

3. Procédé suivant l'une des revendications précédentes,
**caractérisé en ce que** l'on applique la variation du courant électrique passant dans le module (4, 6) de piles à combustible comme grandeur de perturbation à une grandeur de perturbation de la régulation.

4. Procédé suivant l'une des revendications précédentes,
**caractérisé en ce que** l'on règle la température par un réglage d'une puissance d'une pompe (14) pour du fluide de refroidissement.

5. Procédé suivant l'une des revendications précédentes,
**caractérisé en ce que** l'on règle le débit du courant du fluide de refroidissement en fonction de l'intensité du courant (I₁, I₂) électrique passant dans le module (4, 6) de piles à combustible.

6. Procédé suivant l'une des revendications précédentes,
**caractérisé en ce que** l'installation (2) de piles à combustible a au moins deux modules (4, 6) de piles à combustible parcourus respectivement par un courant de fluide de refroidissement et on règle le débit de tous les courants de fluide de refroidissement en fonction du courant (I₁, I₂) maximum des divers modules (4, 6) de piles à combustible.

7. Procédé suivant la revendication 6,
**caractérisé en ce que** l'on réduit le débit d'un courant de fluide de refroidissement passant dans un module (4, 6) de piles à combustible fournissant un courant du module indépendamment du courant de module avant qu'un courant du fluide de refroidissement soit arrêté dans un autre module (4, 6) de piles à combustible.

8. Procédé suivant l'une des revendications précédentes,
**caractérisé par** une régulation de la différence de température du fluide de refroidissement avant et après le module (4, 6) de piles à combustible.

9. Procédé suivant la revendication 8,
**caractérisé en ce que** l'on entre, dans la régulation de correction, le nombre de modules (4, 6) de piles à combustible, qui sont refroidis instantanément par le dispositif (10) de refroidissement.

10. Installation (2) de piles à combustible ayant au moins un module (4, 6) de piles à combustible, un dispositif (10) de refroidissement, pour faire passer du fluide de refroidissement dans le module (4, 6) de piles à combustible, et un moyen (10) de processus prévu pour régler une température du fluide de refroidissement à la sortie du module (4, 6) de piles à combustible,
**caractérisée en ce que** le moyen (8) de processus est prévu pour détecter la température du fluide de refroidissement dans le module (4, 6) de piles à combustible et pour appliquer à la régulation une grandeur de perturbation, déduite de la valeur de mesure, et une variation (I₁, I₂) électrique passant dans le module (4, 6) de piles à combustible comme autre grandeur de perturbation.
